Europäisches Patentamt

European Patent Office

Office européen des brevets

(11) Publication number : **0 681 298 A2**

(12) **EUROPEAN PATENT APPLICATION**

(21) Application number : **95303029.3**

(22) Date of filing : **03.05.95**

(51) Int. Cl.⁶ : **G11C 16/06, A63F 9/22**

(30) Priority : **04.05.94 US 238111**

(43) Date of publication of application :
**08.11.95 Bulletin 95/45**

(84) Designated Contracting States :
**CH DE FR GB IT LI SE**

(71) Applicant : **International Business Machines
Corporation
Old Orchard Road
Armonk, N.Y. 10504 (US)**

(72) Inventor : **Nguyen, Kha D.
9988 Moss Pond Drive
Boca Raton, Florida, 33496 (US)**
Inventor : **Basnett, Don E., Jnr.
1073 NW 50th Drive
Pompano Beach, Florida, 33064 (US)**
Inventor : **Singkornrat, Paripon
2650 Greenwood Terrace,
Apt. No. G222
Boca Raton, Florida, 33431 (US)**
Inventor : **Watzel, Donald J.
5088 Chardonnay Drive
Coral Springs, Florida, 33067 (US)**

(74) Representative : **Moss, Robert Douglas
IBM United Kingdom Limited
Intellectual Property Department
Hursley Park
Winchester Hampshire SO21 2JN (GB)**

(54) **Game programmed flash memory cartridge.**

(57)   Disclosed is a rewritable cartridge that is compatible with commercially available game systems to produce game cartridges at the point-of-sale location. It provides just-in-time delivery of the desired game. Retailers stock uniquely designed game blanks to meet consumer demand. A programming device loads digital content from computer storage to the rewritable game cartridge in an extremely short period of time. The cartridge employs reprogrammable flash memory (30, 32). The unique flash memory enables programming of the rewritable game cartridge in less than 10 seconds. The flash rewritable cartridge (18) contains identification hardware (38) that allows the programmer to verify it as proprietary to a particular manufacturer or authorized dealer. Only those cartridges that are correctly identified are programmed providing a high level of quality control of the manufacturing process. After a cartridge (18) is verified, the operator has the option to initialize the cartridge and input additional information such as store location and cartridge type into the flash memory. The game content can be erased from the cartridge when it is returned, new game content can be programmed and the cartridge can be reused.

FIG. 2

A portion of the disclosure of this patent document contains material which is subject to copyright protection. The copyright owner has no objection to the facsimile reproduction by anyone of the patent document or the patent disclosure, as it appears in the European Patent Office patent file or records, but otherwise reserves all copyright rights whatsoever.

Field of the Invention

The present invention relates to the field of video and audio data storage and controlled production of information, and in particular to video and audio storage in portable cartridges for interactive use, particularly, in video game systems.

Today there are over 50 million video game players in the United States of America alone. The rental and retail of video game cartridges have evolved into a major market as the number of new games has grown to more than 2,000 titles and game prices continue to rise. Consumer studies show that one of the biggest area of dissatisfaction among game renters and buyers is the difficulty of finding their game choice in stock. Game retailers find it difficult to accurately forecast demand for video games because there are usually no archival records to use as a base. Popularity often rises through the informal "word of mouth" networking among game players. In addition, the window of opportunity for a particular game is very short. A retailer who purchases enough game cartridges to meet peak demand may be left with unsold game cartridges when demand diminishes. The opposite problem occurs when a retailer did not purchase enough game cartridges to meet demand. In this case more cartridges will have to be ordered from the manufacturers. This process could lead to loss of revenue due to very long lead times because the cartridges, which contain mask programmable read only memory (MPROM), are usually produced in limited manufacturing runs and often overseas which delays delivery to the retailer.

Presently, retailers must predict consumer demand for MPROM based game cartridges for the game cartridge rental and retailing business. Usually the prediction is not very accurate particularly if it involves a new game title that has no previous marketing record. Retailers are forced to overstock or understock game cartridges resulting in cash flow problems or loss of sales, both causing loss in total profit. If retailers overstock then they may end up with unusable inventory because MPROM game cartridges are not alterable. On the other hand, understocking causes loss in rental or sale revenue because retailers cannot satisfy consumer demand. Further, the efficiencies of programming MPROM, or reprogramming EPROM or EEPROM are such that they are not ideal for on-demand retailing operations.

DISCLOSURE OF THE INVENTION

The game programming system uses rewritable cartridges that are compatible with commercially available game systems (for example, Sega and Nintendo systems) to produce game cartridges at the point-of-sale or rental location. It satisfies the renter or buyer by providing just in time delivery of the desired game. Retailers only have to keep sufficient uniquely designed game blanks on hand to meet consumer demand. No popularity forecast of any particular game title is necessary.

The invention is comprised of a programming device specifically designed to load digital content from computer storage to program a rewritable game cartridge in an extremely short period of time. The game cartridge is of a design that uses reprogrammable flash memory instead of the traditional MPROM or even EPROM or EEPROM. The combination of the unique flash memory concept and the programming device enables this system to program a rewritable game cartridge in less than 30 seconds. Therefore a game cartridge can be manufactured on-demand resulting in greater customer satisfaction. The retailers only have to stock rewritable cartridges utilizing flash memory with its more idealistic features.

The flash rewritable cartridge also contains identification hardware that allows the programmer to verify it as proprietary to a particular manufacturer or authorized distributor or retailer. The programmer is able to program only those cartridges that are correctly identified thus allowing stringent quality control of the manufacturing process. After the programmer identifies a cartridge as usable, the operator has the option to initialize the cartridge and input additional information such as store location and cartridge type into the flash memory. If initialization is not necessary, then the operator can instruct the programmer to begin loading data from storage to the cartridge.

The flash reprogrammable cartridge readily lends itself to the rental business where a game can be programmed on a cartridge and rented to a customer. The game content can be erased from the cartridge when it is returned, new game content can be programmed and the cartridge can be rented a successive number of times. A sell-through scenario is also envisioned and may present the customer with the opportunity to bring an owner's purchased cartridge back to be reprogrammed with a new game title. When flash memory becomes less expensive for cartridge inclusion and sale, a greater profit can be made by programming large numbers of cartridges on demand and selling them to customers. If flash memory prices are relatively high, a sell-through is most feasible by first selling an empty cartridge to a customer, then programming it with the desired game content for an additional fee. After a period of time the customer may tire of the game and desire a new game. In such a case the cartridge is brought back and a new game is purchased but without purchasing a new blank cartridge. This then saves the hardware cost when a customer purchases a new game.

Certain novelties and advantages that the game programming system provides include on-demand swift programming of specially designed cartridges, satisfying consumer needs, programming only those cartridges verified as of proprietary design, programming many types and densities of cartridges, provision for retailers stocking only blank cartridges and never running out of any game title, down loading new game content from remote control server sites to enable immediate distribution of new game titles to retail locations, remote programming of cartridges, where a game programmer box can be many feet from the PC, controlling multiple game programmer boxes by a single PC to save cost and providing a new tool to the store manager to perform analysis of the game business, including identifying popular games, monitoring daily transactions and days of rental and providing inventory analysis (listing cartridges by type and/or density).

BRIEF DESCRIPTION OF THE DRAWINGS

The invention will now be described by way of example only, with reference to the accompanying drawings, in which:

FIGURE 1 is a block diagram of a game programming system in accordance with the principles of the present invention;

FIGURE 2 is a block diagram of the reprogrammable cartridge, as illustrated in FIGURE 1;

FIGURE 3 is a logic flow diagram for the cartridge and game programmer, as illustrated in FIGURE 1;

FIGURE 4 is a block diagram of the game programmer interface card, as illustrated in FIGURE 1;

FIGURE 5 is a block diagram of the game programmer, as illustrated in FIGURE 1;

FIGURE 6 is a block diagram for the game sequencer as illustrated in FIGURE 4;

FIGURE 7 is a block diagram for the software driver design of the hardware FIFO, sequencer and cartridge;

FIGURE 8 is a logic flow diagram of an initialization process for the reprogrammable cartridge, as illustrated in FIGURE 1;

FIGURE 9 is a logic flow diagram of an on-demand manufacturing process of the reprogrammable cartridge, as illustrated in FIGURE 1;

FIGURE 10 is a logic flow diagram of the game writing process;

FIGURE 11 is a logic flow diagram of the game erase process;

FIGURE 12 is a schematic block diagram of a Master Content File for encryption;

FIGURE 13 is a logic flow diagram for encryption of a Content File; and

FIGURE 14 is a logic flow diagram for decryption of a Content File.

DESCRIPTION OF THE ILLUSTRATIVE EMBODIMENT(S)

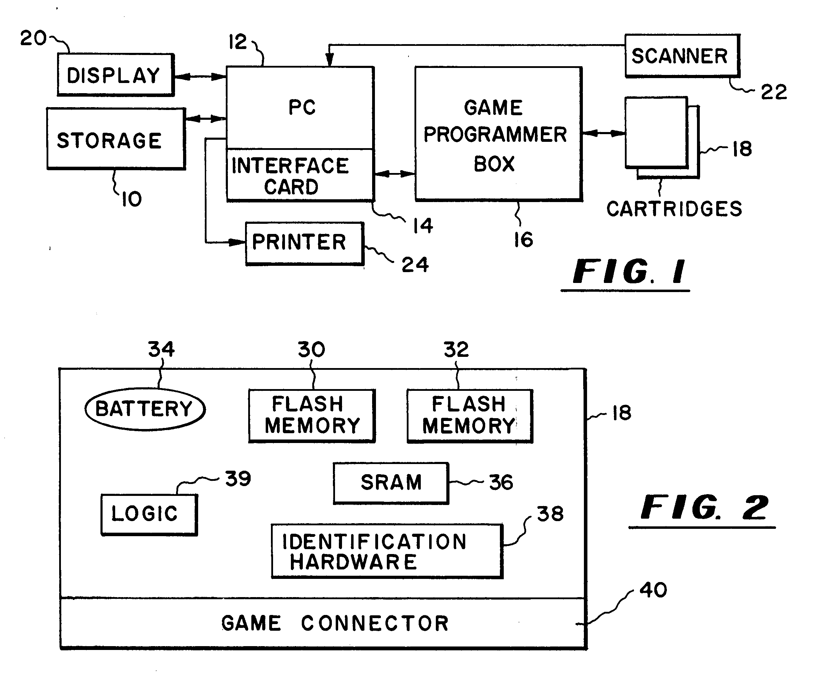

The game programming system of **Fig. 1** comprises a storage subsystem 10, a personal computer (PC) 12, such as an IBM™ PS/ValuePoint™ Mod. No. 6384L00 with 527 MB hard drive equipped with a game programmer interface card 14 that is attached to an external game programmer 16. The innovative concept is integral to the game programmer interface card 14, the game programmer 16, and the programming of a reprogrammable game cartridge 18.

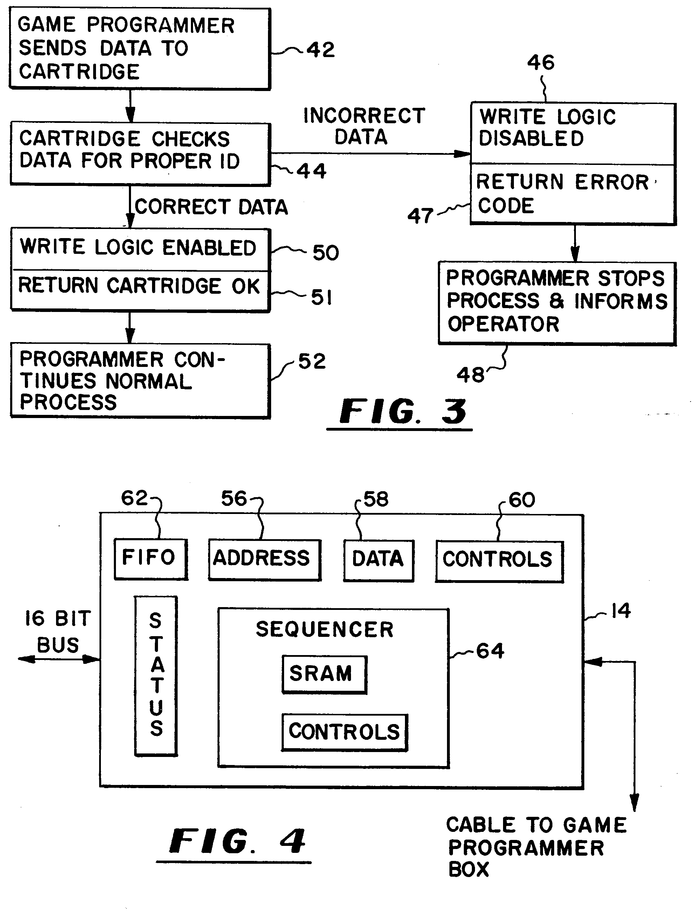

The game interface card 14 provides communication and data transfer between the personal computer 12 and the game programmer 16. The interface card 14 communicates with PC 12 on a 16 bit bus. The interface card 14, as seen in greater detail in **Fig. 4**, contains an address buffer 56, data buffer 58, controls 60, FIFO (first in, first out) memory 62 and a sequencer 64. In a read operation, the game interface card 14 obtains information from the reprogrammable game cartridge 18 plugged into the game programmer at connector 40. The information is passed through the game programmer 16 and then directly on to the PC 12. The PC 12 uses this information to determine the cartridge type and whether it is of a predetermined type, configuration and quality for use by the programming system.

To provide a unique check for proprietary and quality designed game cartridges, a programmable array logic (PAL) or a generic array logic (GAL) 38 is programmed to enable the flash memory 30 and 32 of the cartridge 18 for writing, if and only if the "correct" data stream is sent from the game programmer 16 to the game cartridge 18, as best seen in **FIGURE 3**. The PAL 38 will also send back a "cartridge verified" signal to the game programmer 16. This arrangement accomplishes two goals, a) the game programmer 16 will program only proprietary cartridges and b) other game programmers cannot program proprietary cartridges unless they know the unique data stream that must be provided.

As seen in **Fig. 3**, at step 42 the game programmer 16 sends identification data to the cartridge 18. At the cartridge 18, the data is checked as seen at step 44. If incorrect data is present, an incorrect data signal is sent to the write logic of the sequencer 64 which is disabled at step 46 and a return error code is sent to the game programmer 16 at step 49 which provides for the programmer 16 to stop the process at step 48. If the cartridge identification data is verified, then the write logic is enabled at step 50, a return cartridge OK code is sent to the game programmer 16 at step 51, and the game programmer 16 continues the process through step 52.

As further illustrated, in **FIGURE 2** the reprogrammable game cartridge 18 includes one or more flash memory chips 30 and 32. The illustrated embodiment of the cartridge design with flash memory 30 and/or 32 can be programmed in less than 30 seconds.

The flash memory 30 and 32 also holds retailer usable information such as store identification and cartridge type. The store manager or user application can input this information at cartridge initialization. A battery 34 providing backup for a static RAM (SRAM) 36 are optional and dependent on the requirement of a specific game. Typically, the battery 34 and SRAM 36 are used to hold player scores and other like tally results. The cartridge 18 contains unique identification hardware 38 such as the PAL that identifies it to a particular manufacturer, authorized distributor or retailer. Logic 39 functions to select between the flash memory 30 and 32 and the SRAM 36.

During a cartridge write operation, the game programmer interface card 14 accepts data from the PC 12 and fills the FIFO memory 62 in the interface card 14. The sequencer 64 in the card 14 generates addresses, proper commands, control and timing signals, and sends the game content from the FIFO memory 62 to the game programmer 16 which in turn passes the information to the reprogrammable game cartridge 18. It is the sequencer 64 in the interface card 14 that enables this game programming system to write data to the reprogrammable game cartridge very rapidly.

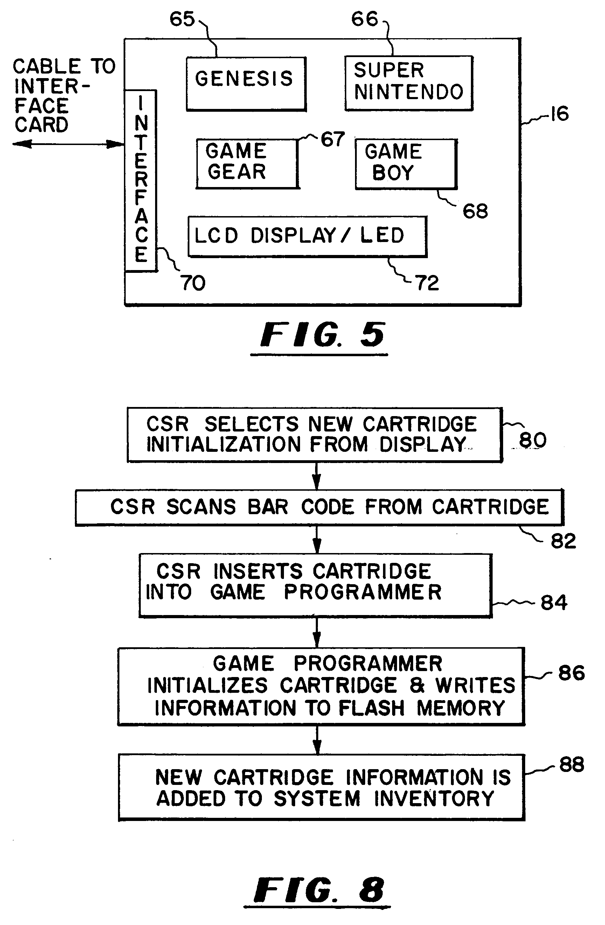

The game programmer 16 provides an interface between the game programmer interface card 14 and reprogrammable game cartridge 18. This programmer 16, as seen in more detail in **Fig. 5**, comprises electronic hardware and physical interfaces 70, including cables. The programmer is adapted to accommodate the plug-in of a number of reprogrammable game cartridges 18 at slots 65, 66, 67 and 68. Cartridges from different manufacturers and game formats have different densities and form factors. For example, a Sega Genesis™ cartridge will not fit into a slot made for a Nintendo SNES™ (Super Nintendo Entertainment System). Moreover, each type of cartridge has different electrical connections. Therefore, four separate slots 65, 66, 67 and 68 are provided in the game programmer 16 or an interposed cartridge adapter is included to accommodate, for example, multiple game formats. Those could include (a) Sega Genesis 65, (b) Nintendo SNES 67, (c) Sega Game Gear™ 67, and (d) Nintendo Game Boy™ 68. More slots can be added to accommodate other formats. Density denotes how much a memory chip or cartridge can hold. Higher density means that more bits are available for use by the video game.

The game programming system provides on demand programming of rewritable flash memory game cartridges for the rental and retail business. Flash memory semiconductor technology was introduced by Intel Corporation in 1988. At the semiconductor technology level Intel's ETOX™ (EPROM tunnel oxide) flash memory is based upon a single transistor EPROM cell. This technology provides high-density, truly nonvolatile and high performance read-write memory solution. The main characteristics of this memory are low power consumption, extreme ruggedness, and high reliability. Low power consumption is particularly evident when compared to other erasable PROM technologies, such as EEPROM and EPROM.

Flash memory technology utilizes a one-transistor cell, providing increased densities, scalability, higher reliability and lower cost, while taking advantage of in-system mass electrical erasability. Moreover, flash memory offers distinct advantages when compared to other solid state memory technologies. For example, in comparison with electrically erasable programmable read-only memory (EEPROM), EEPROM, while being non-volatile is also electrically byte-erasable. This requires a more complex cell structure, resulting in significant different features and capabilities including a limited capacity vs density, lower reliability and higher cost. These make it unsuitable as a mainstream memory. Thus the cell structure of an EEPROM is more complex, (i.e. contains more parts/data-stored) than does flash memory. Moreover, when programming EEPROM, it takes about 10 ms (milli-seconds) to write to each location or cell. When programming flash memory, it takes only 9 μs (micro-seconds) to program each location. In the illustrated instance, with flash memory 30 and 32 (each 8 bits wide, and when addressed, done in parallel for 16 bits), two megabytes may be programmed in less than 10 seconds. This is approximately three orders of magnitude faster than EEPROM.

In an embodiment of the present system, two 8 megabit flash memory chips (Intel™ 28F008SA) are used. This gives 2 megabytes of storage in a single cartridge. Note that the game programmer 16 can handle up to 16 megabytes and should satisfy most memory requirements for game cartridges. The game programmer 16 can also be redesigned without difficulty to accommodate memory cartridges with higher density should that need arise. Time for manufacturing a cartridge has been drastically reduced to less than 30 seconds so that a customer may wait for the product while it is being manufactured without feeling unduly delayed.

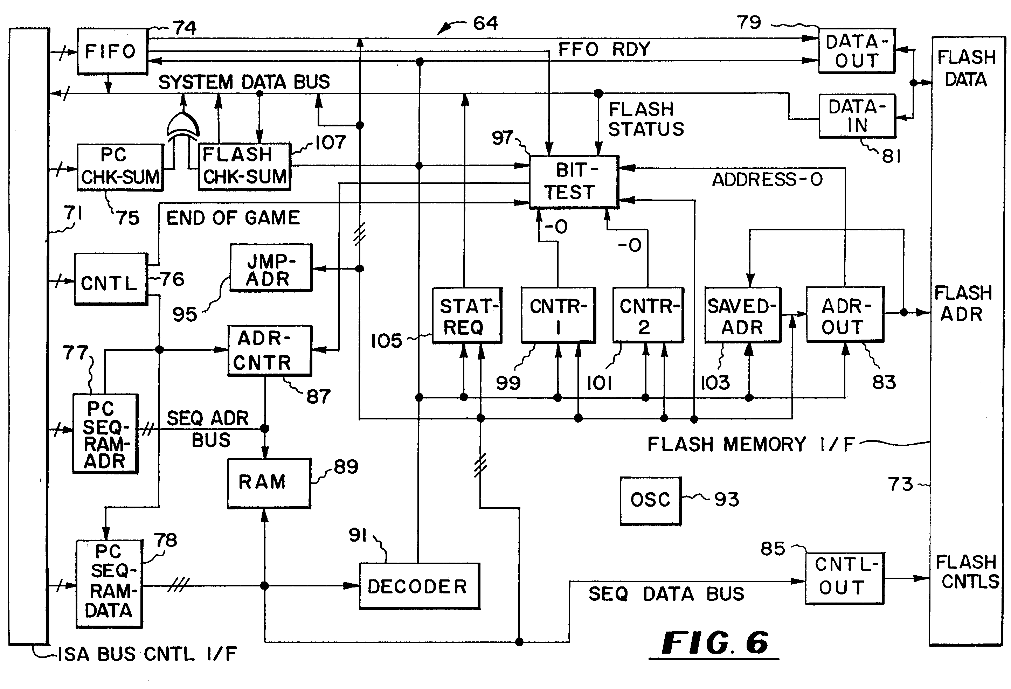

The sequencer (SEQ) 64 of the game interface card 14 is best illustrated in **Fig. 6**. The ISA I/F or ISA bus interface includes the ISA BUS CONTROL I/F 71 and provides control logic to the interface between the ISA bus and SEQ 64. FLASH MEM I/F 73 provides the flash memory I/O signals. FIFO 74, or as shown in **FIG. 4** as FIFO 62, is used by the ISA bus to load game data while the SEQ 64 is carrying out the programming of the flash 30 and 32. The SEQ 64 off-loads the data one by one or in a parcelling manner when the FIFO 74 is not empty. PC CHKSUM 75, which is hereinafter further explained, holds game checksum which was calculated and loaded by software (SW) on the PC.. CNTL 76 is used by the PC SW to signal SEQ 64 to start the programming process and to let SEQ 64 know when the End-Of-Game occurs and is sent forth on the internal control line. PC SEQ-RAM-ADR 77 is used by PC SW to address the SEQ 64 RAM 89 locations. PC SEQ-RAM-DAT 78 is used by PC SW to write data to the SEQ 64 RAM 89 locations.

The SEQ I/F includes the DATA-OUT 79 which functions to place FIFO-data from FIFO 74 to place a command on Flash Memory I/F data bus 73. DATA-IN 81 is used by the SEQ 64 to receive data or status from Flash Memory I/F data bus 73. ADR-OUT 83 functions to allow the SEQ 64 to generate address to access flash memory 30 and 32. CNTL-OUT 85 is used by the SEQ 64 to generate control signals to flash memory 30 and 32.

The sequence engine includes ADR-CNTR 87 which accesses the internal code of SEQ 64 internal code which is stored in RAM 89 and which functions as the code address counter. The RAM 89, as stated, holds the SEQ 64 internal code. This code is loaded by the PC SW after power-on-reset (POR). It is also read back and verified by the PC SW to ensure that the content was loaded correctly. The DECODER 91 of **Fig. 6** decodes the SEQ engine code and generates the appropriate control signals to other registers. An OSC 93 is an oscillator which generates clock for the entire SEQ engine. JMP-ADR 95 acts to hold the jump-address of the code location. If the BIT-TEST 97 is true, its content is loaded into the ADR-CNTR 87. The BIT-TEST 97 is used by the SEQ 64 to test various hardware (HW) status and to determine branch conditions for the SEQ internal code. CNTR-1 99 is used by the SEQ 64 as a general purpose counter and functions as, e.g., a timer, byte count, loop count and delay. CNTR-2 101 is similarly used by the SEQ 64 as a general purpose counter and functions also as a timer, byte count, loop count and delay. A SAVED-ADR 103 is used by SEQ 64 to save the current flash address for later use. While STAT-REG 105 is used by the SEQ 64 to send status to the PC SW, the FLASH CHK-SUM 107 is used by the SEQ 64 to do HW game checksum calculation and compare it with PC CHK-SUM 75.

The BUSES of the sequencer (64), as illustrated in **FIG. 6**, include the SYSTEM DATA BUS marked with a single hash mark across the bus line. This system data bus is accessible by the PC SW. As an input to the PC SW, it is multiplexed from Flash-Data-Bus and SEQ-Status-bus. As an output from the PC SW, it is the ISA Data-Bus. The SEQ ADR BUS is marked with a double hash mark. This is the SEQ RAM Address bus, which accesses the SEQ engine code in RAM 89. The SEQ DATA BUS is marked with triple hash marks. This SEQ data bus has Ob-code-field, Data-field and Control-field. The Ob-Code-field is sent to the decoder 91 as instruction. The Data-field is sent to the registers, including 99, 101 and 105, as an example, as data. The Control-field is sent directly to the flash 30 and 32 as control signals. The Control-field is independent from other fields that is, it can change without affecting other fields' operations. The Ob-code-field normally operates with Data-field. It is also possible to operate without Data-field, i.e., the SAVED-ADR 103 or FIFO 74 can operate without Data-field. Data-field does not work by itself. Registers that can execute in one instruction are FLASH CHK-SUM 107, SAVED-ADR 103, ADR-OUT 83 which can do an increment, DATA-IN 81 which can do a low byte select and CNTR-1 99 and CNTR-2 101 which can do a decrement or increment.

The software interface provides for adapter communication being executed through Port I/O using a single port for all read, write, erase, LCD 72, LED, and status operations. Write operations use the on-board sequencer 64 and FIFO 62 hardware to write data to the flash memory cartridge 18. Since the size of the hardware FIFO 62 is 2KB, all write requests are executed using 1KB blocks, using a flip-flop method for increased performance. Once the data reaches the FIFO 62, the on-board sequencer 64 reads the FIFO 62 and transfers the data to the flash memory cartridge 18. During the write operation the hardware will accumulate a simple 8-bit checksum. When the write operations are completed, the checksum is compared to a software checksum to verify the write operation. In addition, during the write operation the device driver will be checking a write status signal after each data transfer for run-time errors. Write LCD/LED operations are executed using Port I/O on the interface card 14.

Read operations read data directly from the flash memory chips 30 and 32 via the I/O Port and erase operations use the "Flash-Specific" block erase command. The erase commands are unique to each type of flash memory chip.

Software operations using multiple interface cards 14 in a single PC 12 can be synchronous or asynchronous depending on the operating system platform. Software operations on a single interface card 14 attached to game programmer 16 with multiple game cartridges 18 slots 65, 66, 67 and 68 are synchronous. Therefore multiple operation requests to a single interface card 14 are blocked or serialized by software semaphores in a device driver rather than a more complex hardware design. For the hardware microcode driver design, the sequencer 64 on the PC interface card 14 requires a downloadable set of microcode to accommodate data transfer operations between the FIFO 62 and the flash memory 30 and 32. This is the microcode that will control the various game cartridge formats of the game programmer 16 supported by the game manufacturing system. This microcode is downloaded by the game system device driver 116 which also passes commands and data to the sequencer 64 via the card FIFO registers 62. The sequencer internal code controls the following functions: writing of data from the FIFO registers 62 to the flash memory 30 and 32; calculation and comparison of data checksum to verify write operations; and reading of data from flash memory 30 and 32 to the FIFO registers 62.

The advantage of using a sequencer 64 in this application is that the sequencer code can be modified to suit different types of writable ROMs. The sequencer microcode is created much like standard assembly language wherein the steps include the first step of create a source code file using pre-defined opcodes and operands, and the second step of assemble source code file using GASM.EXE (game assembler).

The GASM.EXE command creates two output files from the original source code file. The first is similar to a standard assembler listing (filename.LST), and the second file is the binary sequencer microcode (BSM) file and assumes the BIN extension. One BSM file will exist for each game cartridge type, and all appropriate BSM files will be downloaded to the PC interface card 14 during the device driver initialization process.

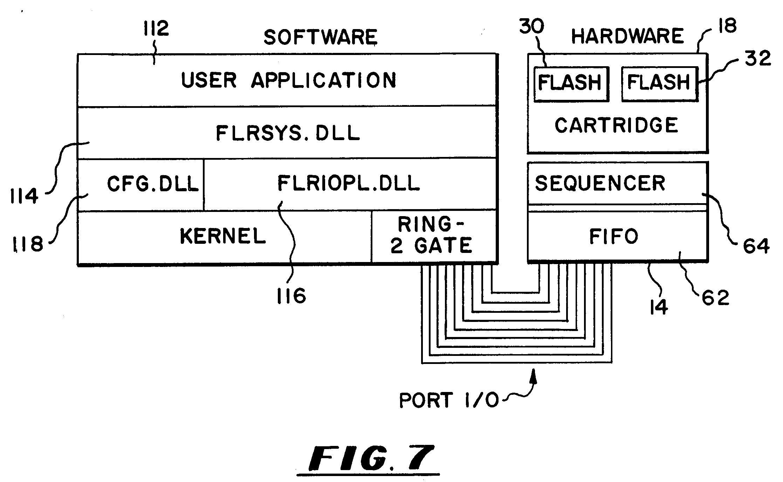

The hardware and software component definition and installation is set forth as follows and is further explained with regard to **Fig. 7**:

| Module | Description | Location |
|---|---|---|
| FLRSYS.LIB | Export library for 32-bit Flash Memory System API's | LIB |
| FLRSYS.DLL | Dynamic Link Library for 32-bit Flash Memory System API's | LIBPATH |
| FLRIOPL.LIB | IOPL (Ring 2, 16-bit) Flash Adapter Driver | LIB |
| FLRIOPL.DLL | IOPL (Ring-2, 16-bit) Flash Adapter Driver Dynamic Link Library | LIBPATH |
| FLRSYS.H | Flash API, error code, and constant definitions | INCLUDE |
| CFG.DLL | Flash Memory System Support API's | LIBPATH |
| FLRSYS.INI | Flash Driver initialization file (used by FLRSYS.DLL) w/FLRSYS.DLL | |

The LIBPATH variable for the modules FLRSYS.DLL, FLRIOPL.DLL and CFG.DLL, respectively blocks 114, 116 and 118 in **Fig. 7**, is defined in OS/2™ 2.x Config.Sys File.

The software driver design employs a strategy, as illustrated in **Fig. 7**, using a Ring-3 32-bit dynamic link library (FLRSYS.DLL) 114 as the software link between the user interface application 112, comprising, for example, the LCD display 72 or a keyboard, and the flash memory driver (FLRIOPL.DLL) 116. The FLRIOPL.DLL is a Ring-2 16-bit IOPL (input/output privilege level) driver that communicates with the PC interface card 14 using Port I/O, as shown in **Fig. 7**.

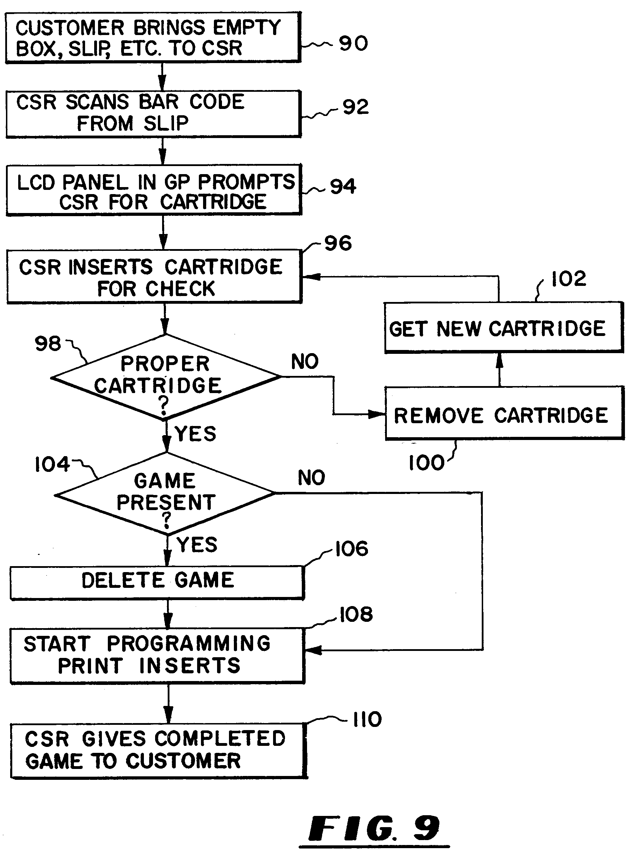

The following scenarios explain how the game programming system of **Fig. 1** is used. A new cartridge initialization procedure, as illustrated and further described in **Fig. 8**, includes the steps of a customer service representative (CSR) selecting new cartridge initialization from the display 20 at step 80. The CSR uses the scanner 22 to scan bar code from the cartridge 18 at step 82. Generally, new unprogrammed cartridges will have bar code indicia on them with the following category information: (1) the store I.D.; (2) kind of cartridge, i.e. Sega, Nintendo, etc. and (3) a cartridge serial number. This information is programmed into a portion of the cartridge flash memory 30 and 32 by the initialization technique (either bar code or computer keyboard etc.). This would normally be done by the business operation in advance of the need for the cartridges. The cartridges are then put into their appropriate bins awaiting usage (i.e. a customer orders a game). Game cartridges that are going to be reused could also be placed in the same bins, because the category numbers associated with the cartridge would already be placed in the cartridge. Other information that would or could be placed in this section of the memory would be the game identification. This would occur when the CSR instructs the manufacturing machine to download a specific game. The CSR inserts the cartridge 18 into the appropriate slot in the game programmer (GP) 16 for engagement of the cartridge game connector 40 at step 84. As previously provided for at step 44 of **Fig. 3** the cartridge 18 identification check is made. The GP then initializes the cartridge 18 and writes bar code information into the cartridge flash memory 30 and 32 at step 86 thereby automatically adding new cartridge information to the system's inventory in storage 10 at step 88.

The on demand game manufacturing, as illustrated and further described in **Fig. 9**, includes the steps of a customer bringing game placard, empty Amaray box, or slip to a CSR at step 90. The CSR initiates the manufacturing process by scanning the bar code, for example, from the empty box or slip at step 92. The LCD panel 72 in the GP prompts the CSR for an appropriate cartridge 18 at step 94. The game programming system checks for a proper cartridge (design, type, and density) at step 96. Once the steps of obtaining and identifying a proper cartridge through steps 98, 100, 102, 96 and back to 98 are completed, the LCD panel 72, as an example or option prompts the CSR to erase the cartridge 16 at steps 104 and 106 if a game is present. If none is present, step 108 provides for the system to begin writing the game cartridge and sends information to the printer 24. The printer 24 produces identification and instructional inserts for the game. Once assembled and completed, i.e., at step 110, the customer's order is satisfied and the transaction is completed.

As hereinbefore stated the game programming system can be modified to program other types of data cartridges. Further, the system is not limited to programming game cartridges.

In a retail store setting a customer reviews and selects a game for manufacture at a game kiosk. The game kiosk may comprise a monitor with preferably a touch screen graphical user interface, although a keyboard serves as a reasonable alternative. The user selects or identifies, in order, (1) the type system the customer has, or chooses to browse games available for purchase or rental; e.g. Sega, Nintendo etc., (2) then selects a category of those games available., i.e. sports, combat, children's etc. and (3) then proceeds to browse the titles and view a short clip showing the characters involved and/or a brief description of the game, including the graphics associated with the games' front cover.

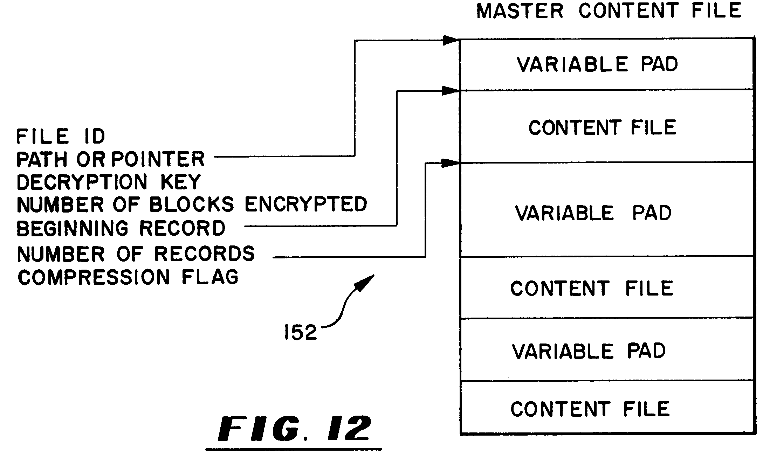

Once the customer has made a decision to select a particular game or games, those selections are made on the touch screen and an order slip is printed out. A slip printer is included a part of the kiosk. The slip is given to the customer service representative (CSR) at the front or retail check-out desk where a point-of-sale register or terminal is located. The printed slip may contain a printed game title and/or a bar code. The bar code contains at least the necessary information concerning the selected game; i.e. the game identifier (ID) or part number. The CSR then processes the slip with the bar code part number at a game storage computer and the slip is scanned, such as by a bar code scanner, into the game storage computer to give the necessary initiating indicia for identification of the game and for the game to be manufactured. Concurrently, an appropriate cartridge is placed into the game programmer 16 ("ROM burner") which reads any information contained in the cartridge. If, for example, the cartridge had been previously rented and contains another game in flash memory plus other cartridge and source information, steps 96, 98, 100 and 102 of **Fig. 9** are invoked. In that event, a portion of the flash memory includes complete inventory information, and means that the cartridge flash memory must be erased before being reloaded, as hereinafter explained with regard to **Fig. 11**.

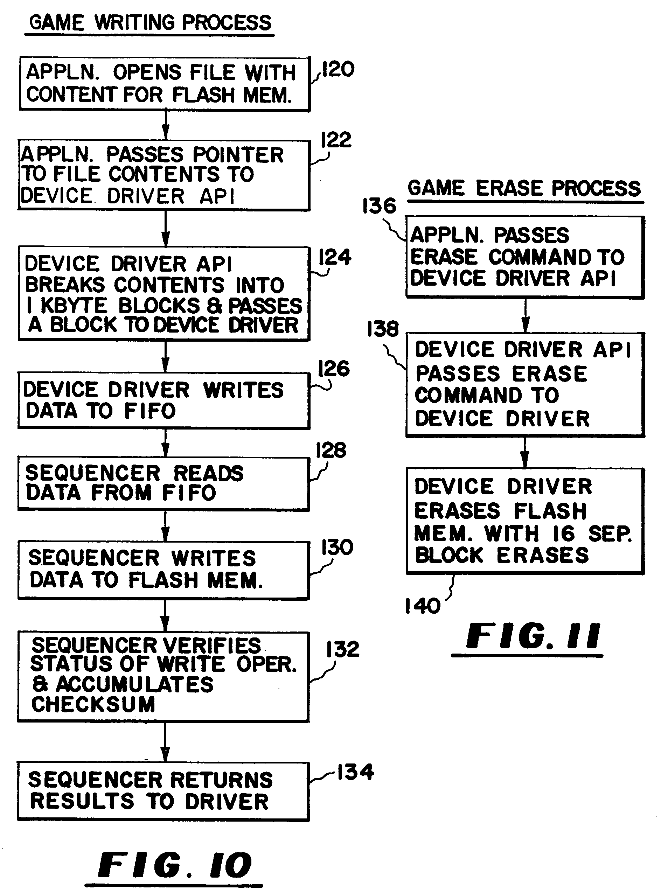

The steps for writing, whether it be a game or other program, are more fully described with reference to **Fig. 10**. Optionally, the content to be written may be encrypted and/or compressed as a file. This is more fully discussed with regard to **Figs. 12-14**. In step 120 the application 112 opens a file with content from the storage 10 which is intended for the flash memory 30 and 32. The application 112 then, in step 122, passes the pointer to the file contents to the device driver API as set forth in **Fig. 7**. Step 124 provides for the device driver API to break the contents for the flash memory 30 and 32 into lkbyte blocks and passes each block individually to the device driver. As earlier explained in **Fig. 7**, step 126 provides for the device driver to write the data to FIFO 62. The sequencer 64 reads the data, in step 128, from FIFO 62. The data is then written by the sequencer 64 to the flash memory 30 and 32 in step 130. The checksum operation previously discussed with regard to **Fig. 6**, is then carried out by the sequencer 64 to verify the status of the write operation in step 132. The sequencer 64, at this point or step 134, returns the results to the device driver. However, if more than one lkbyte block needs to be processed, then steps 126-134 are repeated until all blocks are processed.

The game erase process, as hereinbefore discussed with regard to **Fig. 9**, and in particular steps 104 and 106, is now more fully described with regard to **Fig. 11**. The erase process is dependent on the flash memory parameters present, but in general requires the application 112 to pass the erase command to the device driver API, as covered by **Fig. 7**, and as set forth in step 136 of **Fig. 11**. That command is passed through by the device driver API to the device driver in step 138. At step 140, the device driver acts to erase the flash memory 30 and 32 with 16 separate block erases as was hereinbefore presented. This is dependent on the selected flash memory. Assuming, however, that the flash memory in the cartridge is empty, a pre-activity to the game burning activity is the placement of the bar code on a paste-on strip or the like, and the placement in the cartridge of additional information. This includes another slip with bar code and in a small area of the flash RAM, the following information: (1) the store identifier, (2) the cartridge serial number, (3) the "kind" of cartridge it is, i.e. Sega, Nintendo, etc. and (4) the game part number, is incorporated. During cartridge programming this same information is also placed and is included on the instruction sheet both which are packaged by the CSR. Also, the information is sent to the local store computer, or point of sale computer (i.e. an IBM Mod. 90 computer) which captures all of the information concerning the game to be replicated. This information, in addition to information on check-in/check-out status for rental cartridge is considered transactional information.

In certain retail establishments (e.g. Blockbuster Video stores) the transactional information is transmitted, for example, once per day, or at other convenient intervals and times to the computer at, for example, headquarters of the retail operation. The point-of-sale computer audits the transmission back to the game computer to determine if there is any missing or incorrect information. As, for example, if the store number is incorrect, the point-of-sale computer will send an error code indicating that another cartridge should be placed in the game programmer 16. This would also be true if the cartridge contained, for example, an invalid cartridge serial number.

The CSR also, at the point-of-sale register or monitor, further processes the package instruction and programmed game cartridge. There the cartridge rental information, i.e., the part number, and various identification numbers plus any additional information, e.g., the customer's name, address, may be stored and printed out on a receipt, including rental/sale price, and may also be sent to the local store computer and matched with the information concerning the cartridge I.D. and part number already received by the local store computer.

As is easily recognized from the foregoing description, there is no requirement that the POS register or terminal be directly connected to the game storage computer. However, that is possible and even may be advantageous depending upon the particular store arrangement in order to enhance and automate the commencement of the game-loading and cartridge programming activity.

The game computer has stored therein, for example, in hard-drives, CD ROMS, tape or other local storage media, the game content for all of the games may be produced. A protection system for the file content, is discussed hereinafter with regard to file security. After the game-to-be-produced information or indicia is provided to the game storage computer, and a new or used cartridge is installed, the sequence of loading the game and additional identifying information into the flash memory 30 and 32 is commenced.

Also further connected to the separate or game storage computer, by for example a telephone line, is a host game computer which serves to update the directory of the game computer run remote diagnostics if necessary. The host computer also functions to download to and store new or modified games for later transmission to the game storage computer and also provides for the transmission of other data.

In the game manufacturing system a timer is operating and counting down whenever the game burning application is operational. In addition, a time counter provides for either a preset time and duration or for a predetermined time period for completing, in addition to burning, connect time. Periodically, a connection between the game storage computer and the host computer which could be remotely located is attempted, as, for example, by a modem, satellite or direct line. The system functions in a manner that if a timely connection is not made or is terminated prematurely between the host and the game storage computers, the game burner application time counter, that is always running, will not be reset by the other necessary and regularly transmitted data, such as the accounting data, and the system will only operate for the period of time remaining in the counter and then will cease to function. If the broken connection is not caused by the operator, whether accidentally or otherwise, the operator can request from the host computer a back up password, which will provide a grace period or pardon to enable a temporary and usually short, but extra, time period of selected duration for normal operation of the game burning application. This provides some reasonable time between connections, but will not permit the game burner application to run without first transmitting sufficient support data to and from the host computer within set scheduled time periods or before prolonged periods of time have elapsed.

Accounting for business activities when the game computer connection to the host is made must be done in a timely manner to maintain accountability and to be in accordance with accepted accounting practices. The game burning application will not operate after the two selected periods of time have passed. However, it will reset to normal operation if the connection is resumed and all other data, including support data, is transmitted between the game storage computer and the host system.

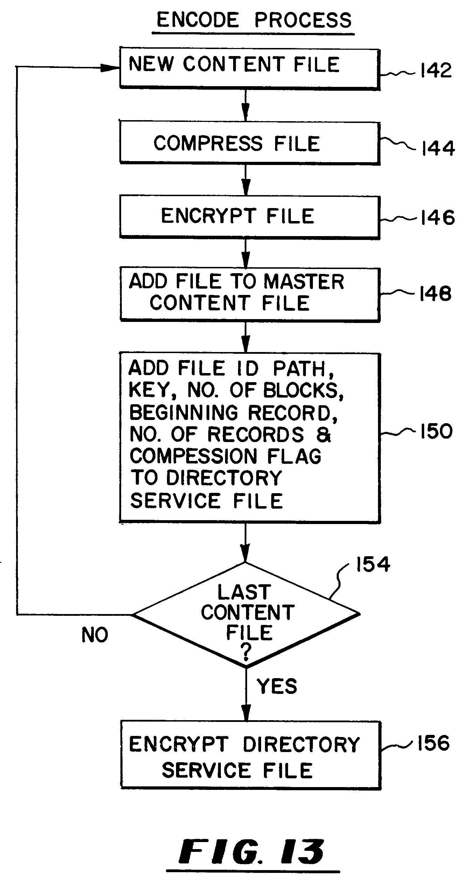

Presented in **FIGS. 12 - 14** is a security process with variations for protecting a computer file from unauthorized access or reading. A number of levels are incorporated to conceal the data and its location on a storage medium. The process incorporates an encrypted directory service file which contains pointers to the actual video game content file and a key for decrypting the content file. The content files are encrypted and can be compressed as well, which comprises and optional step in the process. This method is also applicable regardless of the storage medium employed such as **CD-ROM**, hard disk or via network connection. The video game content files are processed as set forth in **FIG. 13**. **FIG. 13** provides initially for creating a content file base and a Directory Service file by identifying at step **142** a new content file. An optional step **144** provides for compressing the content file. This video compression is carried out following algorithms well known in the art. The next step **146** provides for encrypting the content file, using well known encryption methods. Step **148** provides for creating a master disk file of content file(s) or to copy the content file to storage medium. Thereafter, at step **150** a directory file entry for each content file is created and includes: file ID, pointer/path to content file, decryption key, number of blocks encrypted, beginning record, number of records and a compression flag.

This is illustrated in block form as a Master Content File **152** in **FIG. 12**. Once all content files are processed, as decided at step **154**, the Directory file is encrypted at step **156**.

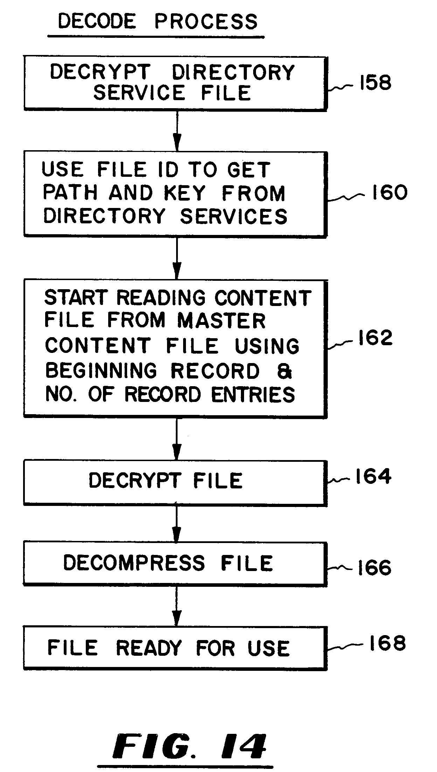

Accessing and reading the content file is set forth in the steps of **FIG. 14**. Decryption of the Directory file transpires at step **158**. At step **160** the Directory file is used to find the content file. It obviously follows that the content file in then read at step **162** in order to start decrypting the content file at step **164**. If the option of compression was practiced at step **144**, step **166** decompresses the content file presenting a file ready for use at step **168**. The Directory Services file generated at step **150** of **FIG. 13** can be encrypted through public key (asymmetric) or private key (symmetric) encryption. Content files are stored separately and can be encrypted via private key (symmetric) encryption. Private key or symmetric encryption means that the sender and receiver each know the key privately and the same key will be used for encryption and decryption. However, public key or asymmetric encryption adds a level of security. The public encryption key is publicly known e.g. by several people. A special software program is used by the intended recipient of the information. With the special program a public key is randomly generated along with a private key, which private key is created by and for one user, the recipient, and only the recipient will know that private key. The private key has a mathematical relationship with the randomly generated public key and each is a function of the other. The recipient uses the private key for decryption only. The sender receives the public key from the intended recipient, the person who is to receive the information, and the sender can enter the public key for encryption only.

This method adds an additional level of security by putting all content files inside of a master content file with variable and random pads for additional obfuscation of the content file's starting and ending points.

While the invention has been particularly shown and described with reference to a detailed description, it will be understood by those skilled in the art that various changes in form and detail may be made therein without departing from the spirit and scope of the invention.

--------------------------------------------------------------------------------

TYPICAL OPERATION

FLASH WRITE OPERATION

PC software


1:    PC SW write to CNTL reg to activate SEQ-Code

2:    Keep Load FIFO with Game content and monitor FIFO status to avoid
      FIFO overflow condition.

3: When at End of Game (EOG), write to CNTL to signal SEQ that EOG is reached.

4: Check for SEQ DONE status and other ERROR status if present.

5: End program and SEQ-Code.


SEQ CODE

1: CNTL-OUT = inactive

2: ADR-OUT = 0

3: DATA-IN = write command


4: CNTL-OUT = write sequence

5: JMP-ADR = 12

6: BIT-TEST, FIFO not empty ?                (jump to 12: if not empty)

7: JMP-ADR = 5

8: BIT-TEST, not E.O.G. ?                     (jump to 5: if not E.O.G.)

9: STAT_REG = Report STATUS & DONE

10: JMP-ADR = 11                              (End SEQ code)

11: BIT-TEST, always true                     (jump to 11:, loop to itself forever)

12: DATA-OUT = FIFO

13: CNTL-OUT = write sequence

14: CNTL-OUT = Read sequence

15: JMP-ADR = 16

16: BIT-TEST, Flash Status not ready          (jump to 16: if Status = not ready)

17: ADR-OUT = increment

18: JMP-ADR = 3

19: BIT-TEST, always true                      (jump to 3:)


FLASH READ OPERATION

PC software

1: PC SW read game content from PC storage and calculate check-sum

2: Write check-sum to PC CHKSUM

3: Write to CNTL to signal SEQ that check-sum was loaded and start read operation to compare check-sum

4: Check for SEQ DONE status, check status, and HW check-sum

5: End program and SEQ-Code

```
SEQ CODE

  1:    CNTL-OUT = inactive
  2:    ADR-OUT = Game Ending address
  3:    CNTL-OUT - Read sequence
  4:    FLASH CHK-SUM = Calculate check-sum
  5:    JMP-ADR = 10
  6:    BIT-TEST, ADR-OUT = 0 ?              (ADR-OUT = 0, game
                                             is read completely)

  7:    ADR-OUT = decrement                  (Decrement address
                                             by 1)

  8:    JMP-ADR = 4
  9:    BIT-TEST, always true                (jump to 4:)
 10:    STAT_REG = Report STATUS & Done
 11:    JMP-ADR = 12                         (End SEQ code)
 12:    BIT-TEST, always true                (jump to 12:, loop; to
                                             itself forever)
--------------------------------------------------------------------
```

**Claims**

1. A plug-in reprogrammable cartridge (18) for digitally receiving in storage computer programs, comprising:
   a cartridge frame;
   flash memory (30, 32) carried by the cartridge frame for digitally receiving computer programs and storing each of said received computer programs in electrically erasable nonvolatile memory;
   programmable logic (39) carried by the cartridge frame for enabling said flash memory (30, 32) for receiving said computer programs upon initial programming and upon reprogramming after erasure; and
   connector means (40) for providing a connection to plug-in the cartridge frame for connecting said flash memory (30, 32) for receiving said computer programs initially and upon reprogramming.

2. A reprogrammable cartridge (18) as claimed in Claim 1, wherein the programmable logic (39) includes identification logic (38) that enables the flash memory (30, 32) for writing if and only if a correct data stream is received by the flash memory means.

3. A reprogrammable cartridge (18) as claimed in Claim 2, wherein the identification logic (38) includes means for returning a verification signal through the connector means (40), the verification signal indicating that the reprogrammable cartridge is a proprietary cartridge.

4. A reprogrammable cartridge (18) as claimed in Claim 2, wherein the identification logic (38) includes a programmable array logic.

5. A reprogrammable cartridge (18) as claimed in Claim 2, wherein the identification logic (38) includes a generic array logic.

6. A reprogrammable cartridge (18) as claimed in Claim 2, further comprising static random access memory (SRAM) (36) for holding tally results.

7. A reprogrammable cartridge (18) as claimed in Claim 6, further comprising a battery (34) for the SRAM (36).

8.	A reprogrammable cartridge (18) as claimed in Claim 2, further comprising logic (39) for selecting between the flash memory (30, 32) and the SRAM (36).

9.	A reprogrammable cartridge (18) as claimed in any preceding Claim, wherein the flash memory (30, 32) has a storage capacity of 2 megabytes.

10.	A reprogrammable cartridge (18) as claimed in Claim 9, wherein the flash memory (30, 32) includes two flash memory units.

*FIG. 1*

*FIG. 2*

GAME PROGRAMMER SENDS DATA TO CARTRIDGE ~42

CARTRIDGE CHECKS DATA FOR PROPER ID ~44

— INCORRECT DATA →

WRITE LOGIC DISABLED — 46

RETURN ERROR CODE ~47

CORRECT DATA

WRITE LOGIC ENABLED ~50

RETURN CARTRIDGE OK ~51

PROGRAMMER STOPS PROCESS & INFORMS OPERATOR

48

PROGRAMMER CON-TINUES NORMAL PROCESS ~52

**FIG. 3**

62  56  58  60

FIFO  ADDRESS  DATA  CONTROLS

16 BIT BUS

STATUS

SEQUENCER ~64

SRAM

CONTROLS

14

**FIG. 4**

CABLE TO GAME PROGRAMMER BOX

14

CABLE TO
INTER-
FACE
CARD

```
┌──────────────────────────────────────────┐
│  I   ┌─── 65 ──┐      ┌─── 66 ──┐         │
│  N   │ GENESIS │      │ SUPER   │      ~16│
│  T   │         │      │ NINTENDO│         │
│  E   └─────────┘      └─────────┘         │
│  R   ┌─────────┐ ~67  ┌─────────┐         │
│  F   │ GAME    │      │ GAME    │         │
│  A   │ GEAR    │      │ BOY     │         │
│  C   └─────────┘      └─────────┘ ~68     │
│  E   ┌─────────────────────────┐          │
│      │  LCD DISPLAY / LED      │          │
│      └─────────────────────────┘ ~72      │
└──────────────────────────────────────────┘
         70
```

## FIG. 5

```
┌────────────────────────────────┐
│ CSR SELECTS NEW CARTRIDGE       │ ~80
│ INITIALIZATION FROM DISPLAY     │
└────────────────────────────────┘
              │
              ▼
┌────────────────────────────────────┐
│ CSR SCANS BAR CODE FROM CARTRIDGE  │
└────────────────────────────────────┘
                                   82
              │
              ▼
┌────────────────────────────────┐
│ CSR INSERTS CARTRIDGE          │
│ INTO GAME PROGRAMMER           │
└────────────────────────────────┘ ~84
              │
              ▼
┌────────────────────────────────┐
│ GAME PROGRAMMER                │ ~86
│ INITIALIZES CARTRIDGE & WRITES │
│ INFORMATION TO FLASH MEMORY    │
└────────────────────────────────┘
              │
              ▼
┌────────────────────────────────┐ ~88
│ NEW CARTRIDGE INFORMATION IS   │
│ ADDED TO SYSTEM INVENTORY      │
└────────────────────────────────┘
```

## FIG. 8

FIG.6

HARDWARE

FLASH  FLASH

CARTRIDGE

SEQUENCER

FIFO

SOFTWARE

USER APPLICATION

FLRSYS.DLL

FLRIOPL.DLL

CFG.DLL

KERNEL

RING-2 GATE

PORT I/O

*FIG. 7*

```
┌─────────────────────────┐
│ CUSTOMER BRINGS EMPTY   │~ 90
│ BOX, SLIP, ETC. TO CSR  │
└─────────────────────────┘
            │
            ▼
┌─────────────────────────┐
│ CSR SCANS BAR CODE      │~ 92
│ FROM SLIP               │
└─────────────────────────┘
            │
            ▼
┌─────────────────────────┐
│ LCD PANEL IN GP PROMPTS │~ 94
│ CSR FOR CARTRIDGE       │
└─────────────────────────┘
            │
            ▼
┌─────────────────────────┐       96
│ CSR INSERTS CARTRIDGE   │                              ┌──────────────────────┐ 102
│ FOR CHECK               │◄───────────────┐            │ GET NEW CARTRIDGE    │
└─────────────────────────┘                │            └──────────────────────┘
            │                               │                      ▲
            ▼                               │                      │
       ◇ PROPER ◇   NO                      │            ┌──────────────────────┐
  98 ◇ CARTRIDGE ◇ ─────────┐               └────────────│ REMOVE CARTRIDGE     │
       ◇   ?    ◇           │                            └──────────────────────┘
            │ YES           │                                    100
            ▼               └────────────►
       ◇ GAME  ◇   NO
 104 ◇ PRESENT ◇ ──────────────────────────┐
       ◇   ?   ◇                            │
            │ YES                           │
            ▼            106                 │
┌─────────────────────────┐                 │
│ DELETE GAME             │                 │
└─────────────────────────┘                 │
            │            108                 │
            ▼                                │
┌─────────────────────────┐                 │
│ START PROGRAMMING       │◄────────────────┘
│ PRINT INSERTS           │
└─────────────────────────┘
            │            110
            ▼
┌─────────────────────────┐
│ CSR GIVES COMPLETED     │
│ GAME TO CUSTOMER        │
└─────────────────────────┘
```

# FIG. 9

## GAME WRITING PROCESS

APPLN. OPENS FILE WITH CONTENT FOR FLASH MEM. — 120

↓

APPLN. PASSES POINTER TO FILE CONTENTS TO DEVICE DRIVER API — 122

↓

DEVICE DRIVER API BREAKS CONTENTS INTO I KBYTE BLOCKS & PASSES A BLOCK TO DEVICE DRIVER — 124

↓

DEVICE DRIVER WRITES DATA TO FIFO — 126

↓

SEQUENCER READS DATA FROM FIFO — 128

↓

SEQUENCER WRITES DATA TO FLASH MEM. — 130

↓

SEQUENCER VERIFIES STATUS OF WRITE OPER. & ACCUMULATES CHECKSUM — 132

↓

SEQUENCER RETURNS RESULTS TO DRIVER — 134

## FIG. 10

## GAME ERASE PROCESS

136 — APPLN. PASSES ERASE COMMAND TO DEVICE DRIVER API

↓

138 — DEVICE DRIVER API PASSES ERASE COMMAND TO DEVICE DRIVER

↓

DEVICE DRIVER ERASES FLASH MEM. WITH 16 SEP. BLOCK ERASES

140

## FIG. 11

MASTER CONTENT FILE

| |
|---|
| VARIABLE PAD |
| CONTENT FILE |
| VARIABLE PAD |
| CONTENT FILE |
| VARIABLE PAD |
| CONTENT FILE |

FILE ID
PATH OR POINTER
DECRYPTION KEY
NUMBER OF BLOCKS ENCRYPTED
BEGINNING RECORD
NUMBER OF RECORDS
COMPRESSION FLAG

152

**FIG. 12**

## ENCODE PROCESS

NEW CONTENT FILE — 142

COMPRESS FILE — 144

ENCRYPT FILE — 146

ADD FILE TO MASTER CONTENT FILE — 148

ADD FILE ID PATH, KEY, NO. OF BLOCKS, BEGINNING RECORD, NO. OF RECORDS & COMPESSION FLAG TO DIRECTORY SERVICE FILE — 150

LAST CONTENT FILE ? — 154

NO

YES

ENCRYPT DIRECTORY SERVICE FILE — 156

# *FIG. 13*

DECODE PROCESS

```
┌─────────────────────┐
│ DECRYPT   DIRECTORY │ ～158
│   SERVICE  FILE     │
└─────────────────────┘
          │
          ▼
┌─────────────────────┐
│ USE FILE ID TO GET  │
│ PATH AND KEY FROM   │ ～160
│ DIRECTORY SERVICES  │
└─────────────────────┘
          │
          ▼
┌─────────────────────┐
│ START READING CONTENT│
│ FILE FROM MASTER    │
│ CONTENT FILE USING  │ ～162
│ BEGINNING RECORD &  │
│ NO. OF RECORD ENTRIES│
└─────────────────────┘
          │
          ▼
┌─────────────────────┐
│   DECRYPT FILE      │ ～164
└─────────────────────┘
          │
          ▼
┌─────────────────────┐
│  DECOMPRESS FILE    │ ～166
└─────────────────────┘
          │
          ▼
┌─────────────────────┐
│ FILE READY FOR USE  │ ～168
└─────────────────────┘
```

*FIG. 14*